# EUROPEAN PATENT APPLICATION

(11) **EP 2 587 535 A1**
(43) Date of publication of application: **01.05.2013**
(21) Application number: 11797551.6
(22) Date of filing: 21.05.2011
(51) Int. Cl.: H01L 23/36

(54) **CERAMIC RADIATION HEAT DISSIPATION STRUCTURE**

(30) Priority: 24.06.2010 CN 201020235811 U
(71) Applicant: JingDeZhen Fared Technology Co., Ltd, Ceramic Industrial Park Jingdezhen City, 333000 Jiangxi (CN)
(72) Inventor: CHEN, Jeong-Shiun, Jiangxi 333000 (CN)
(74) Representative: Gee, Steven William
(86) International application number: PCT/CN2011/074478
(87) International publication number: WO 2011/160520

(57) **Abstract**

A ceramic radiation heat dissipation structure for heat dissipation from a heat source includes a ceramic substrate, a first radiation heat dissipation film and a porous heat dissipation plate. One surface of the ceramic substrate is attached to the heat source and the other surface of the ceramic substrate is provided with a first radiation heat dissipation film. The porous heat dissipation plate is attached to the first radiation heat dissipation film. The porous heat dissipation plate has at least one heat dissipation hole, and an inner sidewall of the at least one heat dissipation hole is provided with a second radiation heat dissipation film. The heat generated by the heat source is fast propagated outwards because of the high efficiency of thermal radiation provided by the first and second radiation heat dissipation films.

## Description

### BACKGROUND OF THE INVENTION

### 1. Field of the Invention

The present invention generally relates to a heat dissipation structure, and more specifically to a heat dissipation structure having a ceramic substrate and radiation heat dissipation films.

### 2. The Prior Arts

In general, many machines and electric equipments generate plenty amount of heat during normal operation, such as an electric motor, engine, combustion chamber, central processing unit (CPU), graphic processing unit, power supply, transformer or power management integrated circuit (IC), or exothermic chemical reaction tank, like fermentation container for fermentation reaction or centralization container for acid-base centralization reaction. Additionally, huge outdoor storage tanks for oil, gas and chemicals need to carefully keep at an appropriate temperature by cooling down in order to maintain the normal operation or avoid any strong reaction, explosion or combustion due to overheat.

The solution to heat dissipation in the prior arts is utilizing heat dissipation plates with considerably large surface area, such as a fin shape of the aluminum heat sink, in order to increase heat dissipation by enhancing heat convention with surrounding air. However, the heat generated by the heat source is thermally conducted to the heat sink and it is not easy to effectively improve the efficiency of heat dissipation due to limited cross sectional area for thermal conduction. Furthermore, the traditional aluminum heat sink is usually large in size and not convenient to use in actual applications as well as the cost is increased. Therefore, it is desired to provide a new ceramic radiation heat dissipation structure to overcome the above problems in the prior arts.

### SUMMARY OF THE INVENTION

Therefore, the present invention has been made in view of the above problems, and it is an objective of the present invention to provide a ceramic radiation heat dissipation structure for heat dissipation from a heat source. The ceramic radiation heat dissipation structure includes a ceramic substrate, a first radiation heat dissipation film and a porous heat dissipation plate. One surface of the ceramic substrate is attached to the heat source such that the heat generated by the heat source is thermally conducted to the ceramic substrate. The other surface of the ceramic substrate is provided with a first radiation heat dissipation film, and the porous heat dissipation plate is attached to the first radiation heat dissipation film. The porous heat dissipation plate has at least one heat dissipation hole, and an inner sidewall of the heat dissipation hole is provided with a second radiation heat dissipation film. Because of the high efficiency of thermal radiation provided by the first and second radiation heat dissipation films, the heat is fastly propagated outwards.

Another objective of the present invention is to provide a ceramic radiation heat dissipation structure for heat dissipation from a heat source, includes a ceramic substrate, a first radiation heat dissipation film and a multicolumn heat dissipation plate. The ceramic substrate is attached to the heat source and a first radiation heat dissipation film is provided on the ceramic substrate. The multicolumn heat dissipation plate is attached to the first radiation heat dissipation film. The multicolumn heat dissipation plate has at least one heat dissipation column, and an outer surface of the heat dissipation column is provided with a third radiation heat dissipation film, which propagates the heat by thermal radiation.

Therefore, the ceramic radiation heat dissipation structure of the present invention can fastly propagate the heat generated by the heat source outwards, and particular, the second radiation heat dissipation film on the heat dissipation hole or the third radiation heat dissipation film on the heat dissipation column provide further thermal radiation so as to enhance the efficiency of whole heat dissipation.

### BRIEF DESCRIPTION OF THE DRAWINGS

The present invention can be understood in more detail by reading the subsequent detailed description in conjunction with the examples and references made to the accompanying drawings, wherein:

Fig. 1 is a schematic view showing one embodiment of a ceramic radiation heat dissipation structure according to the present invention; and

Fig. 2 is a schematic view showing another embodiment of the ceramic radiation heat dissipation structure according to the present invention.

### DETAILED DESCRIPTION OF THE PREFERRED EMBODIMENTS

The present invention may be embodied in various forms and the details of the preferred embodiments of the present invention will be described in the subsequent content with reference to the accompanying drawings. The drawings (not to scale) show and depict only the preferred embodiments of the invention and shall not be considered as limitations to the scope of the present invention. Modifications of the shape of the present invention shall too be considered to be within the spirit of the present invention.

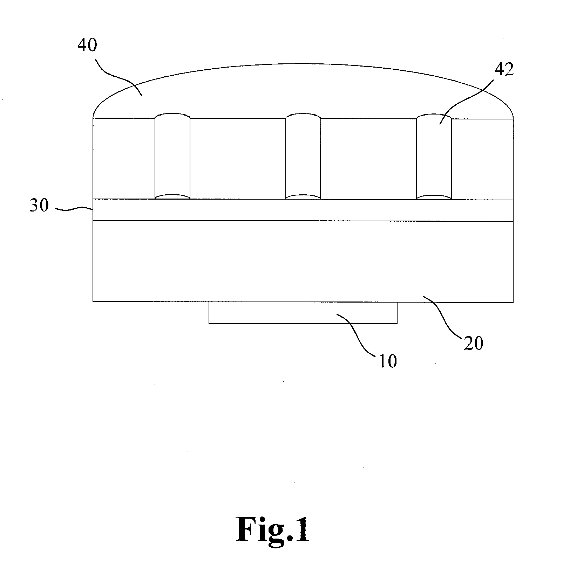

Fig. 1 is a schematic view showing one embodiment of a ceramic radiation heat dissipation structure according to the present invention. As shown in Fig. 1, the ceramic radiation heat dissipation structure of the present invention is used for heat dissipation from a heat source 10, including a CPU (central processing unit), graphic processing unit, power supply, transformer or power management IC (integrated circuit).

Specifically, the ceramic radiation heat dissipation structure of the present invention generally includes a ceramic substrate 20, a first radiation heat dissipation film 30 and a porous heat dissipation plate 40. The ceramic substrate 20 has a first surface (as a lower surface shown in Fig. 1) and a second surface (as an upper surface shown in Fig. 1). The first surface is attached to the heat source 10 such that the heat generated by the heat source 10 is propagated to the ceramic substrate 20 by thermal conduction and the second surface is provided with the first radiation heat dissipation film 30. Besides, the porous heat dissipation plate 40 is attached to the first radiation heat dissipation film 30. That is, the ceramic substrate 20 and the porous heat dissipation plate 40 are on the two opposite surfaces of the first radiation heat dissipation film 30, respectively.

The first radiation heat dissipation film 30 has a specific function of propagating the heat primarily by thermal radiation to conduct heat dissipation. The first radiation heat dissipation film 30 is made from a mixture of metal and nonmetal compounds. The mixture of metal and nonmetal compounds generally consists of a metal compound and a nonmetal compound. More specifically, the metal compound consists of at least one of silver, copper, tin, aluminum, titanium, iron and antimony, or at least one alloy of silver, copper, tin, aluminum, titanium, iron and antimony, or at least one oxide or halide of silver, copper, tin, aluminum, titanium, iron and antimony. The nonmetal compound includes at least one of oxide or nitride or inorganic acid consisting of at least one of boron and carbon.

The porous heat dissipation plate 40 has at least one heat dissipation hole 42. A second radiation heat dissipation film (not visible) is provided on the upper surface of the porous heat dissipation plate 40 and the inner sidewall of the heat dissipation hole 42. The second radiation heat dissipation film is made from the same material as that of the first radiation heat dissipation film 30 and also has the function of enhancing heat dissipation by thermal radiation. Preferably, the whole efficiency of heat dissipation for the ceramic radiation heat dissipation structure of the present invention is further improved by appropriately increasing the number of the heat dissipation hole 42, which provides added thermal radiation.

It should be noted that the heat dissipation hole 42 shown in Fig. 1 is a round through hole as an illustrative example, and apparently not intended to limit the scope of the present invention. That is, the heat dissipation hole 42 can be implemented by other shapes, like triangular, rectangular or polygonal through hole or recess.

Additionally, the present invention may further include a fan (not visible) to enhance thermal convection for heat dissipation by air convention or turbulence. The fan is disposed on an outer side of the porous heat dissipation plate 40, or preferably above the porous heat dissipation plate 40.

One aspect of the present invention is that the heat transferred to the ceramic substrate is propagated through the first radiation heat dissipation film to the porous heat dissipation plate by thermal radiation, and then the second radiation heat dissipation film on the porous heat dissipation plate propagates the heat outwards by thermal radiation.

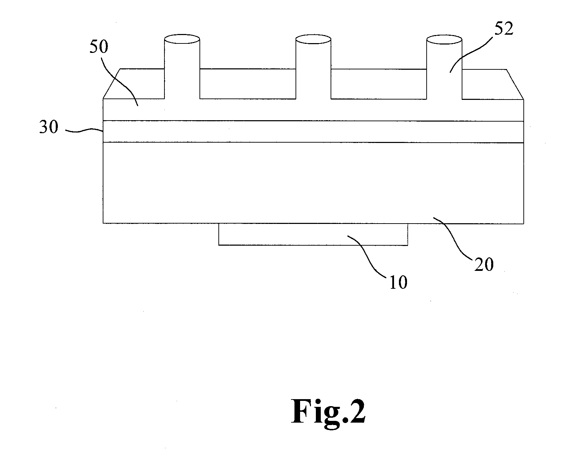

Fig. 2 is a schematic view showing another embodiment of the ceramic radiation heat dissipation structure according to the present invention. As shown in Fig. 2, the ceramic radiation heat dissipation structure of this embodiment includes a ceramic substrate 20, a first radiation heat dissipation film 30 and a multicolumn heat dissipation plate 50. Generally, the ceramic radiation heat dissipation structure in Fig. 2 is similar to the ceramic radiation heat dissipation structure in Fig. 1. The primary difference is that the multicolumn heat dissipation plate 50 is used to replace the porous heat dissipation plate 40. Thus, the detailed description for other elements is omitted hereinafter.

The multicolumn heat dissipation plate 50 has at least one heat dissipation column 52, and the outer surface of each heat dissipation column 52 and the upper surface of the multicolumn heat dissipation plate 50 are provided with a third radiation heat dissipation film (not visible), which is made from the same material as that of the first radiation heat dissipation film 30 and also has the function of enhancing heat dissipation by thermal radiation. Thus, the third radiation heat dissipation film can propagate the heat outwards by thermal radiation. Preferably, the whole efficiency of heat dissipation for the ceramic radiation heat dissipation structure of this embodiment is further improved by appropriately increasing the number of the heat dissipation column 52, which provides added thermal radiation.

It should be noted that the heat dissipation column 52 shown in Fig. 2 is a round column as an illustrative example, and apparently not intended to limit the scope of the present invention. That is, the heat dissipation column 52 can be implemented by other shapes, like triangular, rectangular or polygonal column.

Moreover, the heat source 10 shown in Figs. 1 and 2 is mounted onto the ceramic substrate 20 by a heat dissipation paste (not shown), which can further enhance thermal conduction.

Also, the present invention may further include a fan (not visible) to enhance thermal convection by air convention or turbulence. The fan is disposed on an outer side of the multicolumn heat dissipation plate 50, or preferably above the multicolumn heat dissipation plate 50.

Another aspect of the present invention is that the heat transferred to the ceramic substrate is propagated through the first radiation heat dissipation film to the multicolumn heat dissipation plate by thermal radiation, and then the second radiation heat dissipation film on the porous heat dissipation plate propagates the heat outwards by thermal radiation.

Although the present invention has been described with reference to the preferred embodiments, it will be understood that the invention is not limited to the details described thereof. Various substitutions and modifications have been suggested in the foregoing description, and others will occur to those of ordinary skill in the art. Therefore, all such substitutions and modifications are intended to be embraced within the scope of the invention as defined in the appended claims.

## Claims

1. A ceramic radiation heat dissipation structure for heat dissipation from a heat source, comprising:
a ceramic substrate having a first surface and a second surface, wherein the first surface of the ceramic substrate is attached to the heat source;
a first radiation heat dissipation film provided on the second surface of the ceramic substrate; and
a porous heat dissipation plate attached to the first radiation heat dissipation film and having at least one heat dissipation hole, wherein a second radiation heat dissipation film is provided on an upper surface of the porous heat dissipation plate and an inner sidewall of the heat dissipation hole;
wherein, the first and second radiation heat dissipation films are made from a mixture of metal and nonmetal compound, wherein the first and second radiation heat dissipation films dissipate heat generated from the heat source outwards by thermal radiation.

2. The ceramic radiation heat dissipation structure as claimed in claim 1, further comprising a fan disposed on an outer side of the porous heat dissipation plate.

3. The ceramic radiation heat dissipation structure as claimed in claim 1, wherein the mixture of metal and nonmetal compound consist of at least one of silver, copper, tin, aluminum, titanium, iron and antimony, or at least one alloy of silver, copper, tin, aluminum, titanium, iron and antimony, or at least one oxide or halide of silver, copper, tin, aluminum, titanium, iron and antimony, and one oxide or nitride or inorganic acid consisting at least one of boron and carbon.

4. The ceramic radiation heat dissipation structure as claimed in claim 1, further comprising a heat dissipation paste for mounting the heat source onto the ceramic substrate.

5. A ceramic radiation heat dissipation structure for heat dissipation from a heat source, comprising:
a ceramic substrate having a first surface and a second surface, wherein the first surface of the ceramic substrate is attached to the heat source;
a first radiation heat dissipation film provided on the second surface of the ceramic substrate; and
a multicolumn heat dissipation plate attached to the first radiation heat dissipation film and having at least one heat dissipation column, wherein a third radiation heat dissipation film is provided on an upper surface of the multicolumn heat dissipation plate or on an outer surface of the heat dissipation column,
wherein, the first and third radiation heat dissipation films are made from a mixture of metal and nonmetal compound, and wherein the first and third radiation heat dissipation films dissipate heat generated from the heat source outwards by thermal radiation.

6. The ceramic radiation heat dissipation structure as claimed in claim 5, further comprising a fan disposed on an outer side of the porous heat dissipation plate.

7. The ceramic radiation heat dissipation structure as claimed in claim 5, wherein the mixture of metal and nonmetal compound consist of at least one of silver, copper, tin, aluminum, titanium, iron and antimony, or at least one alloy of silver, copper, tin, aluminum, titanium, iron and antimony, or at least one oxide or halide of silver, copper, tin, aluminum, titanium, iron and antimony, and one oxide or nitride or inorganic acid consisting at least one of boron and carbon.

8. The ceramic radiation heat dissipation structure as claimed in claim 5, further comprising a heat dissipation paste for mounting the heat source onto the ceramic substrate.
